Europäisches Patentamt

European Patent Office

Office européen des brevets

(19)

(11) EP 0 516 436 B1

(12) **EUROPEAN PATENT SPECIFICATION**

(45) Date of publication and mention
of the grant of the patent:
**15.01.1997 Bulletin 1997/03**

(51) Int Cl.6: **H01J 37/34**, C23C 14/34

(21) Application number: **92304870.6**

(22) Date of filing: **28.05.1992**

(54) **Sputtering device**

Sputteranlage

Dispositif de pulvérisation

(84) Designated Contracting States:
**AT BE CH DE ES FR GB GR IT LI LU NL SE**

(30) Priority: **31.05.1991 US 709035**

(43) Date of publication of application:
**02.12.1992 Bulletin 1992/49**

(73) Proprietor: **DEPOSITION SCIENCES, INC.**
**Santa Rosa California 95401 (US)**

(72) Inventors:
• **Bartolomei, Leroy A.**
**Santa Rosa, CA 95404 (US)**
• **Read, Thomas**
**Santa Rosa, CA 95403 (US)**
• **Shevlin, Craig**
**Rohnert Park, CA 94928 (US)**

(74) Representative: **Pendlebury, Anthony et al**
**PAGE, WHITE & FARRER**
**54 Doughty Street**
**London WC1N 2LS (GB)**

(56) References cited:
**EP-A- 0 103 461**    **EP-A- 0 173 164**
**WO-A-90/05793**    **FR-A- 2 218 402**
**US-A- 4 026 787**    **US-A- 4 610 770**

• **PATENT ABSTRACTS OF JAPAN, vol. 7, no. 170
(E-189) 27 July 1983 & JP-A-58 75 839**
• **JOURNAL OF VACUUM SCIENCE AND
TECHNOLOGY: PART A, vol. 4, 1986, NEW
YORK, US; pages 196-201; B. WINDOW ET AL.:
'CHARGED PARTICLE FLUXES FROM PLANAR
MAGNETRON SPUTERING SOURCES'**
• **PATENT ABSTRACTS OF JAPAN, vol. 10, no. 49
(C-330)(2106) 26 February 1986 & JP-A-60 194
073**

## Description

The present invention relates to a device for enhancing the plasma at a sputter target and the use of this device to react a selected material deposited on a substrate.

The use of reactive DC magnetron sputtering to deposit thin films of metallic compounds has been known for quite some time. Most such reactive sputtering has been accomplished in configurations in which the substrate is fixed over the metallic target and compounding of the deposited metallic film occurs at the same time and place as deposition of the metal atoms. The achievement of stoichiometric films at reasonable deposition rates then requires a careful balancing of conditions such that the film on the substrate is fully compounded but the sputter target surface is not, since such "poisoning" of the target leads to much lower sputter rates and, often, arcing at the target surface.

JP-A-5875839 discloses an apparatus for performing sputtering of a target material (3) to coat a static substrate wafer (2) wherein a plasma of gas is produced by the use of microwaves at 2.45 GHz. JP-A-5875839 teaches that in order to increase the plasma density, and therefore to reduce the heating of the target material, the microwave producing device should be positioned in the vicinity of the gas inlet.

In U.S. Patent No. US-A-4,420,385 Hartsough claims a technique in which the substrate on which the metallic compound is to be deposited is alternately passed over the sputter target and through a reactive atmosphere. In this manner deposition of the metal atoms is at least partially separated in time and space from the compounding of the film. The degree of separation depends on the degree of atmospheric isolation between the sputtering and compounding zones.

Hartsough also teaches the use of a plasma in the compounding zone for speeding the rate of reaction. Thus, for example, deposition of an oxide film is enhanced if oxygen in the compounding (oxidizing) zone is activated by a plasma, since excited oxygen species react much more readily with the metallic film than do ground state $O_2$ molecules.

Scobey et al., in U.S. Patent No. US-A-4,851,095 claim a specific embodiment of the general device claimed by Hartsough. While Hartsough claims broadly the separation of the deposition and reaction zones, with no specification or restriction as to the degree of separation, and teaches the advantage of using an activating plasma in the reaction zone, Scobey et al. claim a localized plasma as the reaction zone, and emphasizes the need for this plasma to be physically and atmospherically separated from the deposition zone. In fact, Scobey et al. differentiate from Hartsough's teaching by emphasizing the physical and atmospheric separation of reaction and deposition zones.

There are several shortcomings which are unavoidable consequences of practicing the art as described above. Many of these shortcomings flow directly from the need to physically and atmospherically separate the reaction and deposition zones. For example, this separation obviously limits the number of targets and reaction zones that can be placed in a given vacuum chamber, and the total rate of film deposition is thereby limited. As another example, exposure of the unreacted film between the two noncontiguous zones of Scobey et al. can lead inadvertently to contamination of the growing film by background gases. As yet another example, there are certain synergistic advantages to be gained by continuity and coupling of the activating plasma and the plasma from the sputtering target, which advantages can obviously not be realized if these two plasma zones are physically separated.

The present invention avoids these shortcomings by bringing the sputter and activation zones atmospherically and physically together while eliminating any baffles or differential pumping, thereby effectively blending the plasmas of these two zones into a single, continuous plasma which serves to both sputter material from the target and react it at the substrate.

The present invention provides a magnetron sputtering apparatus for sputter depositing at least one selected material on a substrate and effecting reaction of said material, which apparatus comprises a vacuum chamber, a substrate holder within the vacuum chamber, adapted for mounting substrates thereon, the substrate holder and the vacuum chamber defining therebetween a relatively narrow elongated reaction volume into which a reactive gas is introduced, at least one magnetron sputter device positioned at a first work station adjacent said substrate holder and comprising a target of selected material adapted for generating a first plasma throughout the reaction volume for sputter depositing at least one selected material onto said substrates, and at least one secondary plasma device, characterized in that the secondary plasma device is positioned at the first work station adjacent the magnetron sputter device and adjacent the substrate holder, whereby the sputter device and secondary plasma device respectively provide sputter and activation zones which are atmospherically and physically adjacent. and adapted for enhancing the plasma of the sputter device to effect reaction of ions of the reactive gas with the sputter deposited material at a relatively low ambient partial pressure of the reactive gas and in that the substrate holder is adapted for rotating the substrates past associated selected work stations.

The present invention provides also the use of a magnetron sputtering apparatus as described in claim 29. The dependent claims describe particular embodiments of the invention.

The invention will now be described by way of example only, with reference to the accompanying drawings, in which:-

Fig. 1 is a simplified schematic cross sectional view of a drum vacuum coater in accordance with the present invention.

Fig. 2 is a simplified cross sectional view of a conventional, balanced magnetron sputter device showing the balancing of center and edge magnets.

Fig. 3 is a simplified cross sectional view of an unbalanced magnetron sputter device showing the lack of balance between the edge magnets and center magnet and the resulting diverging magnetic field above the target.

Fig. 4 is a conceptual drawing of the enhanced broadened plasma generated by the present invention, showing the current paths through the plasma and associated generating system.

Fig. 5 is a graph showing a current-voltage characteristic of a magnetron sputter device without an adjacent auxiliary plasma and a current voltage characteristic of a magnetron sputter device operating in accordance with one embodiment of the invention.

Fig. 6 is a simplified schematic view of a preferred embodiment of the invention, showing details of the microwave injection system and electron cyclotron resonance field coils.

Fig. 7 is a simplified cross sectional view of another embodiment of the present invention, showing a microwave form designed to broaden the auxiliary plasma to better match a linear target plasma.

Fig. 8 is a table showing the relation between sputtering yield and voltage for a silicon target.

Fig. 9 is a simplified cross sectional view showing a magnetron sputter device and an adjacent, coupled plasma generating device positioned inside a substrate supporting drum.

Fig. 10 is a simplified cross sectional view showing magnetron sputter devices and associated adjacent, coupled plasma generating devices inside and outside a substrate supporting drum.

Fig. 11 is a simplified cross sectional view of a vacuum chamber with cylindrical inner and outer walls both of which house magnetron sputter devices and associated, coupled auxiliary plasma devices for coating from both sides of a rotating substrate bearing drum.

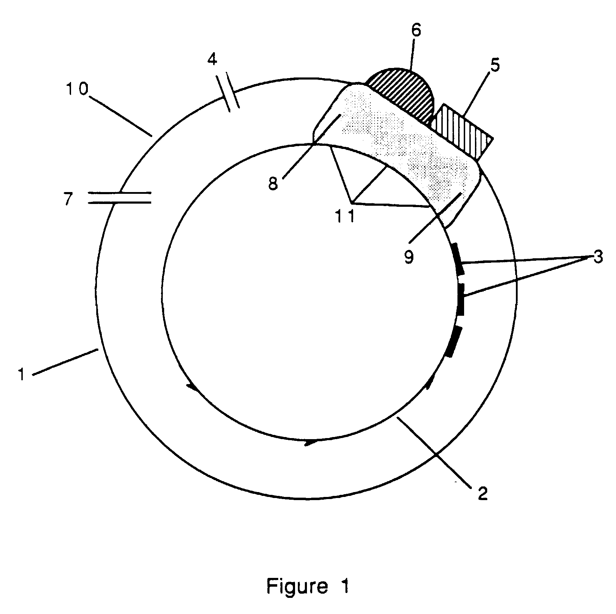

The present invention may be achieved by modifying, in accordance with Fig. 1, a vacuum chamber, housing a rotary drum much like the device disclosed in U. S. Patent US-A-4,851,095 (Scobey et al.), the disclosure of which is hereby incorporated by reference.

Turning to Fig. 1, sputtering system 10 comprises housing 1 whose circumference defines a vacuum or low pressure environment. As such, housing 1 can be connected to a suitable vacuum pumping system (not shown). Under normal operation, the pressure within housing 1 is generally in the range of 0.0133 to 1.33 N/$m^2$ [$10^{-4}$ to $10^{-2}$ Torr]. Magnetron sputtering device 5 is positioned on the circumference of vacuum housing of chamber 1 located in close proximity to plasma generating device 6.

In operation, an inert sputtering gas, such as argon, is injected into the chamber through an input 4. In addition, a compounding gas, such as oxygen, is injected, again through 4. As the substrates 3 supported by rotary drum 2 are rotated into the region 9 of the larger plasma 11, a metal film sputtered from target 5 is deposited. Reaction of this film with the compounding gas begins immediately as the film is deposited in region 9 under the target 5. As the substrate is carried into region 8 of the plasma, under the plasma generating device 6, this reaction continues, completing conversion of the film to a dielectric with the desired stoichiometry. Obviously, this sequence can be repeated through rotation of the drum to build a dielectric film of a desired thickness. By providing additional sputter target-plasma generating devices, multilayer films of various materials can be applied to substrates 3.

As noted previously, the present invention differs significantly from prior devices of this type in that plasma 11 is spatially continuous over target 5 and plasma generation device 6 and compounding of the film is accomplished continuously in plasma 11. In fact, plasma 11 electrically couples the target and plasma generation device. This is in marked contrast to Scobey et al. which specifically teaches the physical and atmospheric separation of the sputtering target and reaction zones.

In a preferred embodiment, plasma generating device 6 (Fig. 1) is a microwave device operating at 2.45 gigahertz. The plasma 11 is then created by the microwaves and the sputter target operating in concert. If the free electron density of the plasma in region 8 is higher than the critical density for microwaves of 2.45 gigahertz, the frequency ordinarily used, then the plasma is substantially opaque to the microwaves and interdiffusion of the plasma in region 8 with the plasma in region 9 renders the plasma continuous. If the plasma is sufficiently transparent to the microwaves, either through an electron density below the critical density or through operating the microwave in a circularly polarized mode so that the so called whistler mode is operative, then the plasma 11 is rendered continuous through both interdiffusion and absorption of microwaves throughout the plasma.

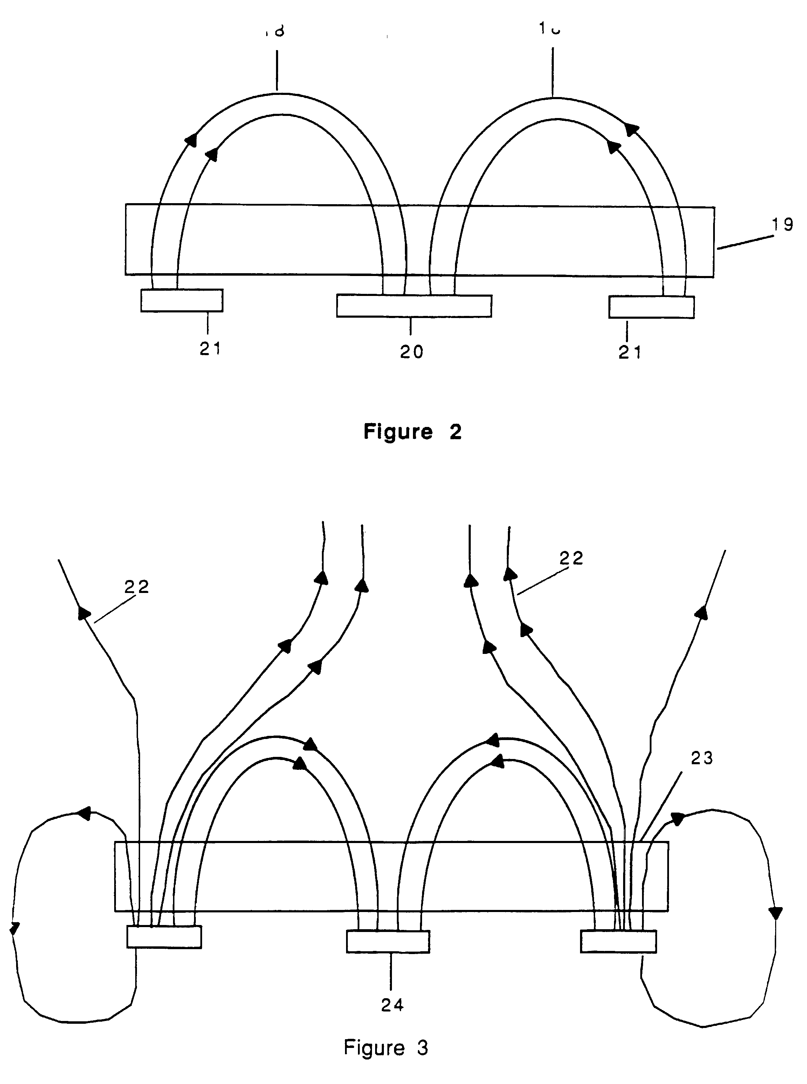

The electrical coupling between the target and plasma generator mentioned above, although always present, can be enhanced, if desired, through design of the magnetic field at the sputter target. In conventional magnetron sputtering targets (Fig. 2), the magnetic field lines 18 are substantially confined to the region just above the target 19. This is accomplished by making the center magnet 20 twice the width of the outside magnet 21, so that all flux from the outside magnets flows through the center magnet. In a newer device (Fig. 3), the so-called "unbalanced magnetron," the center magnet 24 is made smaller or replaced by a magnetically permeable material, so that a part of the flux 22 is "pushed" away from the target 23. This fringing magnetic field carries part of the plasma away from the target and toward substrate 3 (Fig. 1) and contiguous plasma generating device 6 (Fig. 1). In addition to increasing the electrical continuity of the sputter-activation plasma, operation in this unbalanced mode can have other beneficial effects, as discussed below.

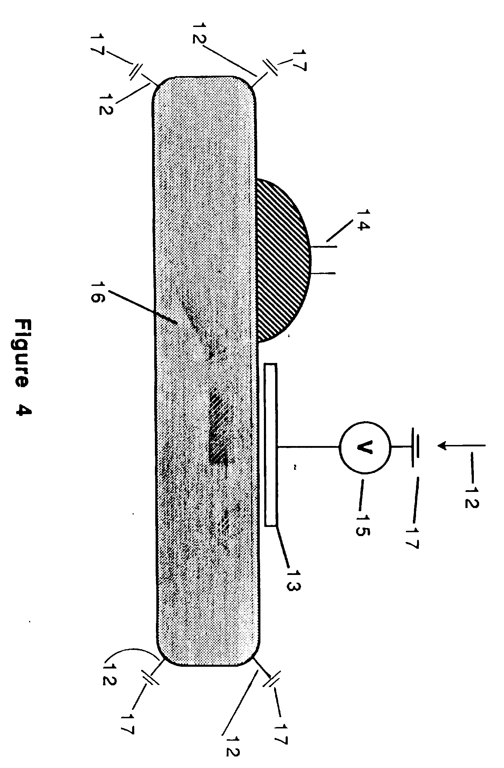

Because the plasma 11 is spatially continuous, it is electrically continuous and regions 8 and 9 of the larger plasma 11 are electrically coupled; that is, there exists, through this plasma coupling, an electrical coupling of the sputter target and microwave device, in marked contrast to Scobey et al. To show this, plasma 11 of Fig. 1 is shown in detail in Fig. 4 as plasma 16. The current in plasma 16 is complex, consisting of both ion and electron components. However, the external current, through ground 17 to the power supply 15 and through the power supply to sputter target 13, is all electronic. Thus, through the plasma 16 there is a net electron current flow equal to that which passes through the power supply 15. The plasma thus acts as a resistive current-carrying element. As Fig. 4 demonstrates, the electron current can go to ground from the plasma at any number of points 12, depending on machine configuration, tooling and other considerations. But in any instance, an electron current is pulled from the plasma as voltage is applied to the target 13.

For given operating conditions, the plasma-ground-power supply-target circuit will exhibit a particular voltage at which the target strikes a plasma. Below this voltage, there will be no current. But as soon as the plasma is struck, the power supply begins to pull current from the plasma, the current increasing with increasing target voltage.

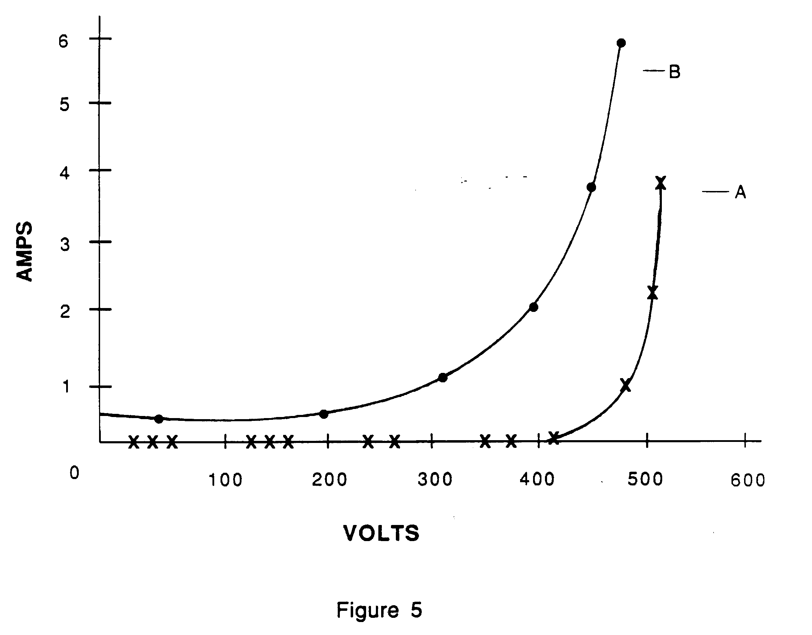

A typical current (I) -voltage (V) curve for a 0.127 to 0.381 m [5" x 15"] silicon target is shown as curve A of Fig. 5 where the microwave device does not contribute to plasma generation. That is, the microwave is not used in generating Curve A. The curve, as developed from experimental data, shows that below a particular voltage (410 volts in this case) at which the target struck a plasma, there was no current, but as the plasma was struck, the power supply began to pull current from the plasma.

By contrast, reference is made to curve B of Fig. 5 which was based upon data generated by initially setting the sputter target voltage to 0 while striking a plasma using only the microwave device. Visually, it was observed that this plasma extended to envelop the sputter target. When voltage to the sputter target power supply was increased from 0, the power supply began immediately to pull current from the microwave generated plasma. As the voltage was increased further still, so that positive ions accelerated to the target caused secondary electron emission from the target surface, the sputter power supply began to contribute to the plasma. By measuring I as V was increased under these conditions, curve B was generated.

In comparing curves A and B, two points are noted. First, it is quite obvious that significant current is drawn from the microwave plasma, even before the target plasma strikes. Secondly, the target plasma strikes at a lower voltage if the microwave plasma has been struck prior to applying voltage to the target. In fact, on curve B it is sometimes not clear at what point the target plasma is struck, in marked contrast to the situation of curve A.

From these two observations, it is clear that the sputter magnetron and microwave device operate as an integral unit in the generation of a plasma and that changing one influences the operation of the other. This is made clearer still by noting, for example, that as the microwave power increases, the voltage required to maintain a given current through the magnetron sputter supply decreases. This is explained by noting that the increased microwave power lowers the resistance of the plasma.

The apparatus of the present invention is capable of achieving higher sputter rates when compared to prior devices. Higher sputter rates follow from the ability of the sputter cathode to draw current from the microwave-induced part of the plasma. This increase in rate is obvious at voltages less than the sputter target striking voltage without the microwave plasma. In reference once again to Fig. 5, at 370 volts, which is below the 410 volts required to strike a plasma with the target power supply alone, the sputter rate is zero without a plasma being created by the microwave device (Curve A). At 370 volts, however, there is a significant sputter rate when operating pursuant to the present invention. (Curve B)

This ability of the present invention to draw ion current from the plasma at low voltages allows sputtering at voltages lower than those of corresponding prior art devices. Since the energy distribution of sputtered atoms shifts toward higher values with increased sputter ion energy, this ability is particularly advantageous in reducing the number of atoms sputtered with higher energies to minimize damage to the growing film.

It was also observed that the sputter rate is increased at voltages higher than the striking voltage. This can be appreciated by considering the yield curve for the sputtered material and the dependence of sputter rate on yield and current; "yield" simply meaning the number of target atoms sputtered for each ion striking the target.

When operating the target in the unpoisoned mode the sputter rate in atoms per second is essentially given by the relationship.

$$R = C_1 Y \qquad (1)$$

where:

$C_1$ is a constant dependent upon target geometry;
I is the target ion current in amperes; and
Y is the yield in number of atoms sputtered for each ion incident on the target.

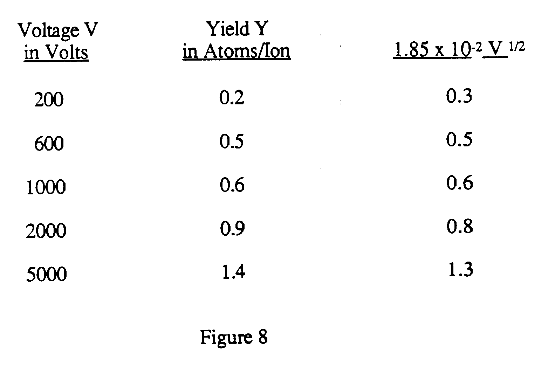

The yield Y is a function of the target voltage V. This function can be measured and is indicated in Fig. 8 for silicon sputtered in argon. Examination shows that the function is well approximated by

$$Y = 1.85 \times 10^{-2} V^{1/2} \qquad (2)$$

substituting (1) into (2) gives

$$R = C_2 I V^{1/2}$$
$$= \frac{C_2 P}{V^{1/2}} \qquad (3)$$

where P=IV is the power and $C_2 = 1.85 \times 10^{-2} C_1$, a constant.

Now, in a practical system, the maximum sputter rate is limited by the power that can be applied to the target without damage by debonding from the backplate or warping through over heating. Thus, to obtain the maximum sputtering rate, the power is increased to the maximum possible. In order to appreciate that the present invention yields higher sputter rates at this maximum power, if R' and I' are the rate and current without the microwave device contributing to plasma generation, then from equation (3)

$$\frac{R}{R'} = \frac{C_2 P V'^{1/2}}{C_2 P' V^{1/2}}$$

$$\frac{R}{R'} = \frac{V'^{1/2}}{V^{1/2}} \qquad (4)$$

since P=P' the maximum power feasible. Since V', the voltage required at maximum power without the microwave device is greater than V, the voltage required with the microwave device, the sputter rate R is greater than the rate R'.

When this greater sputtering ability is combined with use of an efficient oxidizing device, such as the microwave generated plasma in one of the preferred embodiments, the rate of oxide deposition can be much higher than has been therefore achieved. For example, use of the present device has resulted in deposited clear $SiO_2$ at over-the-target rates exceeding $1.8 \times 10^{-8}$ m/s [180 Å/sec], nearly double those reported in U.S. Patent No. US-A-4,420,385. This is also true for other materials as well, as the following discussion reveals.

It has also been observed that the present invention increases the oxygen, or other reactive gas, that can be introduced into the vacuum chamber before the target surface becomes completely covered by an oxide layer; that is, before the target is "poisoned." This results from the ability of the enhanced plasma to create active oxygen species which readily react with the growing film. This film is in effect a second pump for the reactive gas, the vacuum system pump being the first. The pumping speed of the second pump is greater as the oxygen, or other reactive gas, is made more reactive. In one embodiment, the device operates with 2 to 3 kw of microwave power distributed over a plasma 0.203 to 0.254 m [8 to 10 inches] in length. This is in marked contrast to the few hundred watts over 0.508-0.635 m [20-25 inches] cited in U.S. Patent No. US-A-4,420,385, for example. This high input power into the broadened enhanced plasma of the present invention is especially effective in exciting the reactive gas and therefore in increasing the pumping speed of the growing film.

While it is often desirable to operate the system with the maximum reactive gas possible before target poisoning, it is sometimes not desirable. Because of its effectiveness in generating active species, the enhanced plasma device of the present invention often provides complete oxidizing, or nitriding, etc, at reactive gas flows well below the target poisoning level. This mode of operation is often convenient when very stable operation is desired; that is, when operation away from the poisoning knee of the system curve is desired.

It has further been observed that in some embodiments the present invention is capable of striking a plasma at much lower pressures than those normally used in magnetron sputtering. Typically, a DC magnetron requires pressure higher than $0.133 \text{ N/m}^2 [10^{-3} \text{ Torr}]$, while the present invention is capable of striking a plasma at pressures well below $1.33 \times 10^{-2} \text{ N/m}^2 [10^{-4} \text{ Torr}]$. Thus, the present invention is capable of drawing sputtering current at pressures for which the mean collision path is greater than 50 cm. This can be advantageous when line-of-sight deposition is required; that is, when scattering of the sputtered atoms is detrimental to the growing film. This can, for example, prevent high angles of incidence deposition which can lead to porous or stressed films.

Low pressure operation is achieved by using a microwave generator as the plasma enhancing device. Referring to Fig. 1, the microwaves into the system through 6 reflect from the metal drum 2, causing an intense standing wave in the region above the drum 2, the region in which the plasma is desired. Thus the drum 2 becomes part of a high Q microwave cavity in which intense fields capable of plasma generations at pressures down to approximately $6.7 \times 10^{-2} \text{ N/m}^2 [5 \times 10^{-4} \text{ Torr}]$ can be struck and maintained.

To operate the invention at pressures below $1.33 \times 10^{-2} \text{ N/m}^2 [10^{-4} \text{ Torr}]$, electron cyclotron resonance (ECR) operation is required. ECR is a well known phenomenon. It occurs when the electron rotation frequency about an imposed constant magnetic field B matches the frequency of a superimposed electromagnetic field. This electron cyclotron frequency is given by

$$f = \frac{eB}{m} \qquad (5)$$

where e and m are the electron charge and mass. For a microwave frequency f of 2.45 gigahertz, a frequency in common use because of the ready availability of microwave oven magnetrons, B in equation (5) is 0.0875 tasla [875 Gauss].

In the present invention the magnetic field B for ECR operation can be generated in any number of ways. For example, a current carrying coil can be wrapped around the microwave waveguide as it enters the vacuum chamber. Alternatively one can simply place a permanent magnet in the region of the microwave windows on the chamber. When this done, an ECR induced plasma will strike in those regions around the magnet where the magnetic field is 0.0875 tasla [875 gauss].

The present invention is also capable of depositing some non-oxide dieletrics more effectively than is possible using prior art. For example, titanium nitride, TiN, is a well known coating, often used as an antiwear coating. In its optimum antiwear form it is conductive and golden yellow in color. Titanium dioxide, on the other hand, is a clear coating often used in optical filters. Titanium metal reacts readily with oxygen but is essentially nonreactive with nitrogen. To obtain a good TiN film one thus needs a plasma to excite the nitrogen and render it more reactive, and one needs to exclude oxygen from the deposition system to the maximum degree possible.

When the present invention is used to deposit thin films of TiN, a titanium target is employed and nitrogen gas bled into the system after an initial pumpdown. The pumpdown removes oxygen from the system, with temperature and vacuum chamber history being important variables in determining the time required. For example, if the chamber has a thick, porous coating on its walls from previous runs, then a long time may be required for water vapor to be desorbed from the walls. As such, there will always be some residual oxygen in the system and this oxygen will compete with nitrogen in reacting with the sputtered Ti film. Because oxygen is so much more reactive than nitrogen, even a small amount can be detrimental.

In operating the present invention to deposit TiN, substrates are placed upon the drum which is, for example, rotated at 30 rpm. Assuming that the microwave source is positioned on the counterclockwise side of the magnetron sputter target as shown in Fig. 1, the Ti metal is sputtered only in the vicinity of the magnetron whereupon the substrates pass directly into the zone dominated by the microwave device. As such, exposure to background oxygen is minimal, since the reaction started at the site of the target is completed at the site of the microwave device and no free Ti is available for reaction after passing through the microwave input zone.

When the drum is rotated clockwise, the Ti is partially reacted below the sputter target and this partially reacted film is exposed to oxygen background for a period of somewhat less than two seconds in duration, which is the amount of time required for rotating the drum until the substrates reach the microwave device. This can result in potential oxidation of the film.

It can be seen from the above discussion that when operating in a scheme as suggested by U.S. Patent No. US-A-4,851,095, where the sputter target and microwave reaction zones are physically separated, greater care must be exercised to eliminate residual oxygen from the system when depositing non-oxide/metal films in which the metal reacts relatively readily with oxygen. The time spent in the free space between active zones cannot be minimized by the prior art approach as it can in practicing the present invention where there is a single, continuous activating zone. The practical result of this is that the present invention provides for shorter pumpdown times and less attention to machine cleanliness than does the prior art, resulting in an economic advantage.

Other advantages of the present invention arise from an embodiment in which the sputter target is configured in the unbalanced mode as briefly described earlier in reference to Fig. 3. It is well known that the quality of a thin film can be influenced through bombardment of the film by energetic atoms during deposition. The energy of these atoms is preferably great enough to move atoms around on the growing film and small enough to avoid significant sputtering of the film. To restate, it is desirable to increase the mobility of the atoms while avoiding their resputtering. This is best accomplished when the energy of the bombarding species is between about ten and one hundred electron volts. The unbalanced magnetron of Fig. 3 provides ions at the substrate in this energy range. This occurs because the free electrons in that part of the plasma in the diverging magnetic field above the target are guided by that field toward the substrate. These electrons gain energy in moving toward weaker field regions through the magnetic mirror effect. Although the positive ions, the species to which it is desired to impart the preferred substrate bombardment energy, are too heavy to be guided significantly by the diverging magnetic field, they will be accelerated toward the substrate by ambipolar-diffusion; that is, the negatively charged electrons will "drag" the ions along with them.

The unbalanced magnetron can be used as the sputter target in the present invention with plasma enhancement and broadening being provided by, for example, the microwave system discussed above as part of a preferred embodiment. It can also be used as the auxiliary plasma generator in conjunction with a contiguous sputter target which itself may or may not be unbalanced. In this mode the unbalanced auxiliary would operate in the poisoned mode to provide an intense plasma while sputtering at a low rate and the sputter target per se would operate in the unpoisoned mode to provide the desired metal atoms at a high rate. This dual operation of two targets, one poisoned and one unpoisoned, is easily achieved even though the reactive gas pressure is the same over both by simply running the sputter target at a power high enough to insure that it does not poison while running the auxiliary at a power low enough to insure that it does poison.

In using a sputter target, either balanced or unbalanced, as the auxiliary device to enhance and broaden the sputter plasma, a problem arises as to what material the auxiliary target is to be made. In the discussion above it was implicitly assumed that the auxiliary target was of the same material as the main sputter target, so that any material sputtered from it would simply add to the growing film and not contaminate it. This can sometimes be inconvenient and/or less efficient than desired in enhancing the plasma, the latter when insufficient power is applied without cleaning the auxiliary target of it's poisoned surface layer. Another approach that can often be used is to make the auxiliary target of another material that has a low sputter yield or the incorporation of small amounts of which into the growing film is of no practical consequence. Thus, for example, to deposit $Al_2O_3$ one can use a poisoned Si target as an auxiliary and an unpoisoned aluminum target as the main. Since even in the unpoisoned state silicon has a sputtering yield less than one half that of the aluminum, very little silicon would be incorporated into the film, and this as $SiO_2$. For most applications this small amount of $SiO_2$ in $Al_2O_3$ would be insignificant.

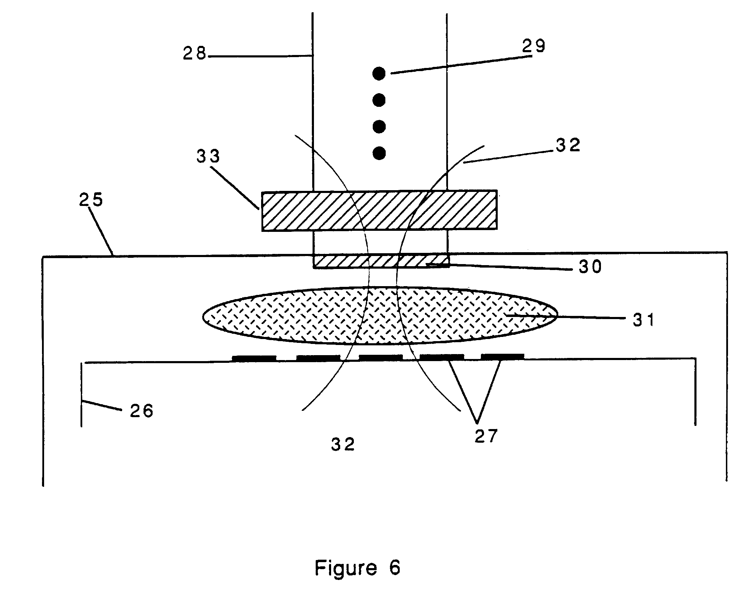

A preferred embodiment of the present invention utilizes a microwave generator as the plasma enhancement device 6 of Fig. 1. One embodiment is shown in Fig. 6 as a side view of the vacuum chamber 25 and rotable drum 26 on which substrates 27 are mounted. A microwave transparent window 30 made of, for example, fused quartz, is mounted on the wall of the chamber. A waveguide 28 directs microwaves through the window 30 enhancing the plasma 31.

The microwave frequency is 2.45 GHz and the waveguide and window are suitably sized for this frequency. Thus the waveguide is WR284, which is rectangular and measures 7.62 cm x 3.81 cm [3 inches x 1.5 inches]. The window is circular and approximately 3 inches in diameter. The microwave power supply is capable of generating 3 kw of microwave power. This is tuned to the plasma 30 using a stub tuner 29 in the waveguide 28.

The sputter target (not shown in Fig. 6) in one embodiment is 0.127 m x 0.381 m [5" x 15"] and is positioned on the outside circumference of the vacuum chamber 25 adjacent to the microwave window 30. The separation of the target and window is typically less than about 0.254 m [ten inches], allowing the plasma 31 to diffuse readily between the microwave window 30 region and the target region so that the advantages of the invention as discussed previously can be realized. When the vacuum chamber is examined after operation, a rainbow-like coating is observed at the microwave window. This is a metal oxide coating formed by metal atoms from the sputter target and oxygen, and it evidences a coupling of the plasmas generated at the target and the microwave generating device as well as a significant excitation of metal and oxygen atoms in the entire region of the continuous plasma.

When operation at pressures lower than about 6 x $10^{-2}$ N/m$^2$ [0.5 millitorr] is desired, a magnetic field 32 is generated in the plasma 31 by a current carrying coil 33 wrapped around the waveguide 28. The ampere turns in this coil are sufficient to create a field strength of 0.0875 tasla [875 G] over some surface in the plasma 31, thereby causing ECR operation at that surface. It has been found that 400 amperes through 75 turns is sufficient to accomplish this.

In addition to providing ECR operation, the magnetic field 32 can also act as a magnetic mirror to keep the hot plasma 31 away from the window 30, thereby allowing higher power without damaging the window or vacuum seals. In fact, the magnetic mirror effect occurs at field levels below those needed for ECR operation and the invention can be so operated if desired.

With a single microwave input such as shown in Fig. 6, a film deposited on substrates 27 spaced over 0.2-0.3 m [8-12 inches], the exact width depending on plasma power, can be reacted. This is because reactive species of the plasma 31 readily diffuse to regions, beyond the 3 inch microwave window 30. When activation over a wider region is desired to achieve, for example, greater load sizes, the number of microwave inputs, each the same as shown in Fig. 6, can be used. For example, three such sources readily suffice for use with a 0.63 m [25"] target, the three plasma zones diffusing into each other and into the region under the target.

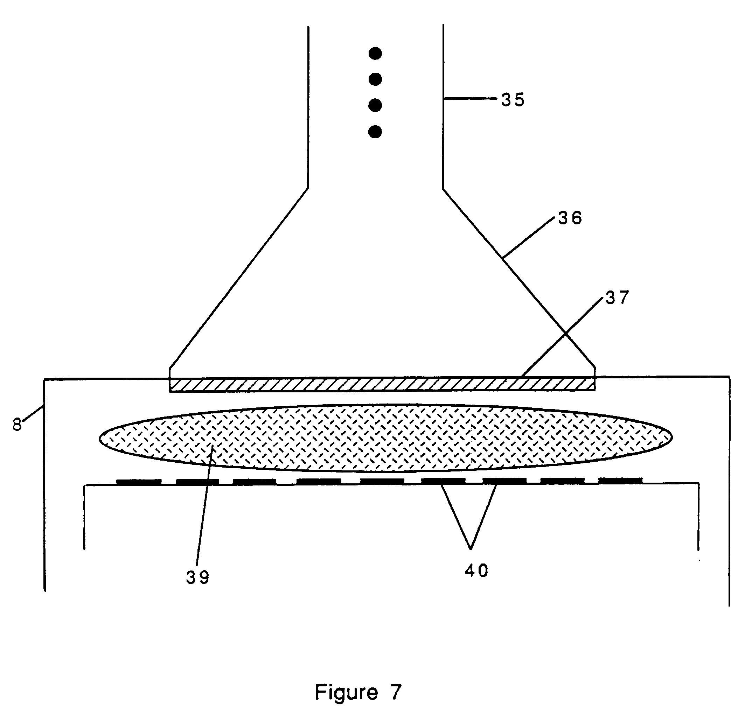

In lieu of such separate inputs, the invention can also utilize a microwave horn as shown in Fig. 7. In this embodiment microwaves are injected through a WR284 waveguide 35 into a microwave horn 36. The length of this horn along the drum is approximately 0.381 m [15 inches] when used with a 0.635 m [25"] target. The microwave window 37 mounted in the chamber wall 38 is rectangular, measuring 38.1 cm x 7.62 cm [fifteen inches by 3 inches]. In this arrangement a long plasma 39 is created allowing activation of film on substrates 40 and coupled operation with the sputter target (not shown).

Other arrangements for introducing the microwaves into the chamber, such as the use of the fringing field applicators sold by Gerling Laboratories of Modesto, California, will be apparent to those skilled in the art.

Example 1

To produce a TiN film on substrates 3 the device as depicted in cross-section in Fig. 1 was configured with a titanium metal target and the deposition conditions listed in table 1 were established.

Table 1

| Target Material | Titanium |
|---|---|
| Argon Flow | 60 sccm |
| Nitrogen Flow | 30 sccm |
| Total Pressure | 0.4 $N/m^2$ [3.0 Millitorr] |
| Target Power | 2 kw |
| Microwave Power | 1.5 kw |
| Drum Rotation Rate | 30 rpm |

Drum 2 was first rotated counterclockwise to produce Sample A and the direction of rotation reversed to a clockwise direction to create Sample B. The resulting films were partially transparent but Sample B more so than Sample A. The conductivity of Sample A was measured at 10 ohms/square while that of Sample B was 25 ohms/square. These measurements clearly indicate that Sample A was better nitrided than Sample B. Stated differently, Sample B was partially oxidized by its longer exposure to the oxygen background.

Example 2

To produce a film of $SiO_2$ on substrates 3 the device as depicted in Fig. 1 was configured with a silicon target and a microwave plasma generator with deposition conditions listed in Table 2. Under these conditions a clear, fully oxidized film of $SiO_2$ was obtained at an over the target deposition rate of $1.8 \times 10^{-8}$ m/s [180 Å/sec]. This is much greater than the $1 \times 10^{-8}$ m/s [100 Å/sec] achieved by U.S. Patent No. US-A-4,851,095 using separate sputter and deposition zones.

Table 2

| Target Material | Silicon |
|---|---|
| Argon Flow | 60 sccm |
| Nitrogen Flow | 35 sccm |
| Total Pressure | 0.33 $N/m^2$ [2.5 Millitorr] |
| Target Power | 4 kw |
| Microwave Power | 2 kw |
| Drum Rotation Rate | 50 rpm |
| Deposition Rate | $1.8 \times 10^{-8}$ m/s [180 Å/sec] |

Example 3

To deposit tantalum pentoxide the device as depicted in Fig. 1 was configured with a tantalum metal target and the deposition conditions listed in Table 3 were established. Under these conditions a clear film of $Ta_2O_5$ was deposited at an over the target rate of $1.2 \times 10^{-8}$ m/s [120 Å/sec] which was obtained without baking the part after deposition; a process commonly used to complete oxidation of thin films as taught in U.S. Patent No. US-A-4,851,051.

Table 3

| Target Material | Tantalum |
|---|---|
| Argon Flow | 60 sccm |
| Nitrogen Flow | 40 sccm |
| Total Pressure | 0.33 $N/m^2$ [2.5 Millitorr] |
| Target Power | 2.7 kw |
| Microwave Power | 2.2 kw |
| Drum Rotation Rate | 50 rpm |
| Deposition Rate | $1.2 \times 10^{-8}$ m/s [120 Å/sec] |

Example 4

For many materials, such as $Ta_2O_5$ and $Nb_2O_5$, deposition rates can be increased if a post deposition bake can be used to complete reaction of the film; that is, to remove residual absorption from the film. This is true for the present invention. To deposit $Ta_2O_5$ the device was configured as depicted in Fig. 1 and the deposition conditions listed in Table 4 were established and a one micron film was deposited at a rate of $2.1 \times 10^{-8}$ m/s [210 Å/sec]. The film was absorbing upon removal from the coating chamber but cleared after baking for 30 minutes at 600° C. This is in contrast to the $1.5 \times 10^{-8}$ m/s [150 Å/sec] achieved in U.S. Patent US-A-4,851,095.

Table 4

| Target Material | Tantalum |
|---|---|
| Argon Flow | 60 sccm |
| Nitrogen Flow | 35 sccm |
| Total Pressure | 0.33 $N/m^2$ [2.5 Millitorr] |
| Target Power | 4.0 kw |
| Microwave Power | 2.2 kw |
| Drum Rotation Rate | 40 rpm |
| Deposition Rate | $2.1 \times 10^{-8}$ m/s [210 Å/sec] |
| Post Bake | 30 min. at 600°C |

Example 5

To produce a film of AlN the device as depicted in Fig 1 was fitted with an aluminum target and the deposition conditions of Table 5 were established. Under these conditions a hard, clear film of AlN of 3.5 μm (microns) thickness was produced at an over the target deposition rate of $5 \times 10^{-9}$ m/s (60Å/sec). This film was very suitable as a transparent wear resistant coating.

Table 5

| Target Material | Aluminum |
|---|---|
| Argon Flow | 60 sccm |
| Nitrogen Flow | 30 sccm |
| Total Pressure | 0.33 $N/m^2$ [2.5 Millitorr] |

Table 5 (continued)

| Target Material | Aluminum |
|---|---|
| Target Power | 3 kw |
| Microwave Power | 2 kw |
| Drum Rotation Rate | 40 rpm |
| Deposition Rate | $6 \times 10^{-9}$ m/s [60 Å/sec] |

The present invention has a wide variety of applications, including multilayer interference filters, opaque wear resistant coatings, transparent wear resistant coatings, layered ultrathin coherent structures (LUCS), transparent conductive coatings, and others. Some of these applications are briefly described below.

The invention was employed to deposit a conductive tin oxide using a tin target and a microwave generated auxiliary plasma. The resulting coating was clear with conductivity $10^{-4}$ ohm-cm.

The invention is also suitable for depositing filters on lamps. For example, a filter transmitting in the visible and reflecting in the infrared, out to about 2 μm, has been used as an energy device for incandescent lamps, especially tungsten halogen lamps. The reflected infrared energy maintains the filament temperature at a given level with less electrical input, thereby yielding visible light at lower cost. Such filters and lamps are well known. They are produced in volume by The General Electric Co., and are described in U.S. Patent US-A-4,851,095. These IR reflecting filters on lamps can be deposited using the present invention by providing tooling to rotate the lamps as they pass through the sputtering - activating plasma. $Nb_2O_5/SiO_2$ and $TiO_2/SiO_2$ have been used as material pairs to make the filters.

Many products require high reflection in the visible and transmission in the infrared, so that the light reflected is "cold." Examples are dental mirrors and smaller parabolic reflectors in which a lamp is positioned at the focal point. So-called MR 16's form an example of the latter. These are half paraboloids measuring 5 cm [16 eighths of an inch] across. They are used, for example, in overhead projectors. The present invention is particularly suitable for coating these MR 16's. It's high deposition rates allow very stable oxides to be deposited economically in this commodity product.

By using two or more targets coupled to auxiliary plasma generators it is easy to deposit alternating ultrathin layers of different materials by controlling the drum rotation rate and the sputter rate. For example, a structure consisting of $6 \times 10^{-10}$ m [6 Å] layers of $SiO_2$ interleaved with $1 \times 10^{-9}$ m [10Å] layers of $TiO_2$ to a total film thickness of 1 μm is readily made at a drum rotation rate of 10rpm, and three and five kilowatts of power respectively to the silicon and titanium target.

While the drum configuration of Fig. 1 is a convenient arrangement for use of the present inventions, it is by no means the only one possible. Any of the configurations of U.S. Patent US-A-4,851,095 would benefit from the use of the invention.

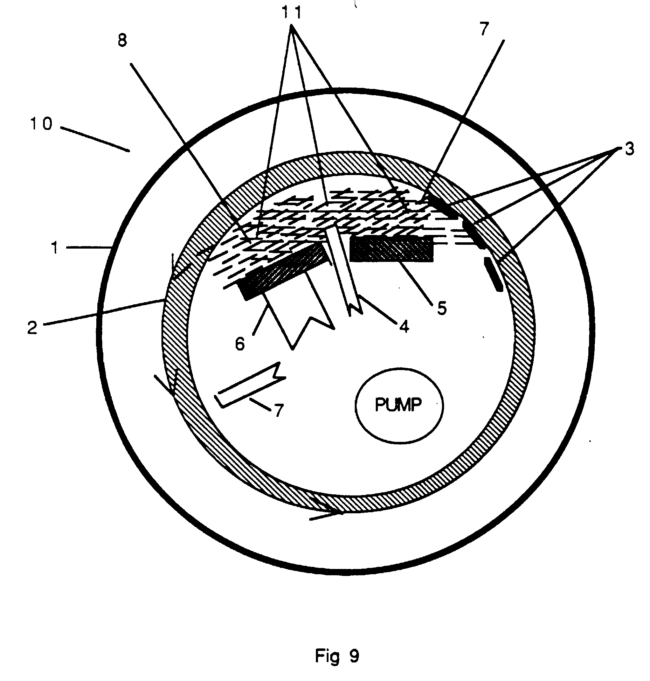

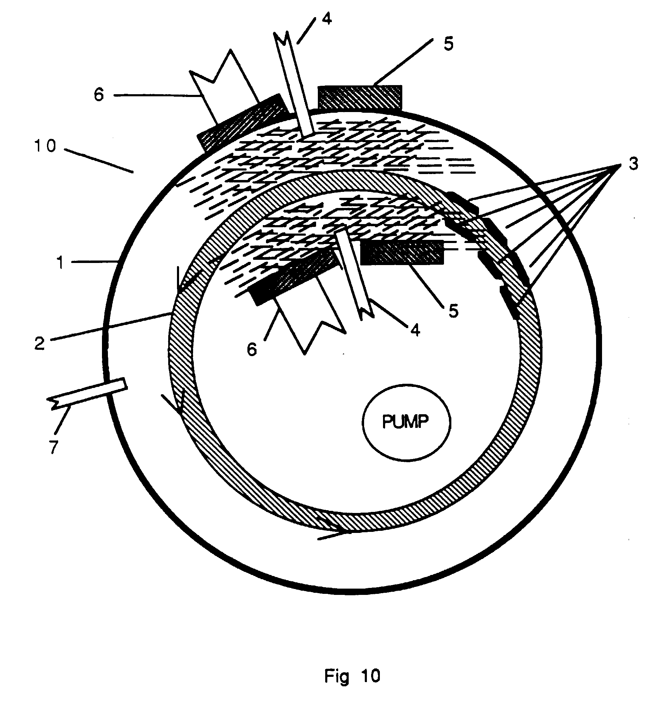

For example, Fig. 9 shows an auxiliary plasma generating device 6 coupled to a sputter target 5 on the inside of a rotating, substrate bearing drum 2. As another example, Fig. 10 shows coupled auxiliary devices 6 and sputter targets 5 on both the inside and outside of a substrate bearing drum 2.

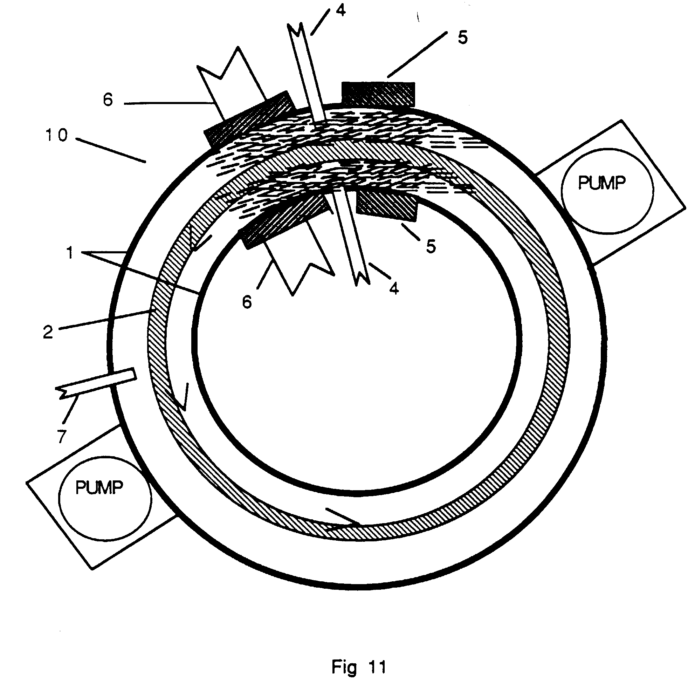

Fig. 11 shows a novel "donut" configuration in which the vacuum chamber 1 has cylindrical inner and outer vacuum walls 1 with coupled auxiliary devices 6 and sputter targets 5 mounted in the walls 1. It is obvious that such a configuration allows coating of substrates facing either in or out on the drum and therefore effectively doubles the load size.

**Claims**

1. A magnetron sputtering apparatus (10) for sputter depositing at least one selected material on a substrate (3) and effecting reaction of said material, which apparatus comprises a vacuum chamber, a substrate holder (2) within the vacuum chamber, adapted for mounting substrates thereon, the substrate holder and the vacuum chamber defining therebetween a relatively narrow elongated reaction volume into which a reactive gas is introduced, at least one magnetron sputter device (5) positioned at a first work station adjacent said substrate holder and comprising a target of selected material adapted for generating a first plasma (9) throughout the reaction volume for sputter depositing at least one selected material onto said substrates, and at least one secondary plasma device (6), characterized in that the secondary plasma device is positioned at the first work station adjacent the magnetron sputter device and adjacent the substrate holder, whereby the sputter device and secondary plasma device respectively provide sputter and activation zones which are atmospherically and physically adjacent, and adapted for enhancing the plasma of the sputter device to effect reaction of ions of the reactive gas with the sputter deposited material at a relatively low ambient partial pressure of the reactive gas and in that the substrate holder is adapted for rotating the substrates past associated selected work stations.

2. A magnetron sputtering apparatus (10) according to claim 1, wherein the enhanced plasma device comprised of the magnetron sputter device (5) and the secondary plasma device (6) is adapted for providing a reactive atmosphere (11) selected to at least partially convert said selected material to at least one of an oxide, a nitride, a hydride, an oxynitride or a carbon-containing alloy or compound.

3. A magnetron sputtering apparatus (10) according to claim 1, wherein the secondary plasma device (6) in combination with the magnetron sputter device (5) is adapted for providing a reactive atmosphere (11) selected to complete conversion of the selected material to at least one of an oxide, a nitride, a hydride, an oxynitride or a carbon-containing alloy or compound, said conversion being initiated by said magnetron sputter device.

4. A magnetron sputtering apparatus (10) according to any one of the preceding claims, wherein the secondary plasma device (6) is adapted for in situ cleaning to the substrate (3).

5. A magnetron sputtering apparatus (10) according to any one of the preceding claims, wherein the secondary plasma device (6) is adapted for bombardment of the selected material by energetic atoms during deposition.

6. A magnetron sputtering apparatus (10) according to any one of the preceding claims, wherein the secondary plasma device (6) is a microwave generator device.

7. A magnetron sputtering apparatus (10) according to claim 6, wherein the secondary plasma device (6) is a microwave generator device operating in an electron cyclotron resonance (ECR) mode.

8. A magnetron sputtering apparatus (10) according to any one of claims 1 to 5, wherein the secondary plasma device (6) is an ion gun device.

9. A magnetron sputtering apparatus (10) according to any one of claims 1 to 5, wherein the secondary plasma device (6) is a linear magnetron device operated in a balanced magnetic mode.

10. A magnetron sputtering apparatus (10) according to any one of claims 1 to 5, wherein the secondary plasma device (6) is a linear magnetron device operated in an unbalanced magnetic mode.

11. A magnetron sputtering apparatus (10) according to claim 9 or 10, wherein the linear magnetron device (6) is comprised of a target material that is the same material as the selected material and is operated in a poisoned mode.

12. A magnetron sputtering apparatus (10) according to claim 9 or 10, wherein the linear magnetron device (6) is comprised of a target material that is a lower sputter yield material than the selected material.

13. A magnetron sputtering apparatus (10) according to any one of the preceding claims, wherein the secondary plasma device (6) provides heating to the substrate.

14. A magnetron sputtering apparatus (10) according to any one of the preceding claims, wherein the magnetron sputter device (5) is a cylindrical magnetron device.

15. A magnetron sputtering apparatus (10) according to any one of claims 1 to 13, wherein the magnetron sputter device (5) is a planar magnetron device.

16. A magnetron sputtering apparatus (10) according to claim 15, wherein the planar magnetron device (5) is operated in an unbalanced magnetic mode.

17. A magnetron sputtering apparatus (10) according to any one of the preceding claims, wherein the magnetron sputter device (5) in combination with the secondary plasma device (6) is adapted for sputter coating of the selected materials at pressures below $133,3 \cdot 10^{-3}$ Pa ($10^{-3}$ Torr).

18. A magnetron sputtering apparatus (10) according to any one of the preceding claims, wherein the magnetron sputter device (5) in combination with the secondary plasma device (6) is adapted for conversion of said selected material to an oxide, a nitride, a hydride, an oxynitride or a carbon-containing alloy or compound at pressures below $133,3 \cdot 10^{-3}$ Pa ($10^{-3}$ Torr).

19. A magnetron sputtering apparatus (10) according to any one of the preceding claims, wherein the substrate holder (2) is a web in a web-to-web roll coater.

20. A magnetron sputtering apparatus (10) according to any one of claims 1 to 18, wherein the substrate holder (2) is a disk.

21. A magnetron sputtering apparatus (10) according to any one of claims 1 to 18, wherein the substrate holder (2) is a drum.

22. A magnetron sputtering apparatus (10) according to claim 21, wherein the secondary plasma device (6) is positioned outside the drum (2).

23. A magnetron sputtering apparatus (10) according to claim 21, wherein the secondary plasma device (6) is positioned inside the drum (2).

24. A magnetron sputtering apparatus (10) according to claim 21, wherein at least one secondary plasma device (6) is positioned inside the drum (2) and at least one secondary plasma device is positioned outside the drum.

**25.** A magnetron sputtering apparatus (10) according to any one of claims 21 to 24, further comprising substrate support means rotatably mounted adjacent the circumference of the drum for rotatably presenting selected substrates (3) or surface segments thereof to the work station (5,6).

**26.** A magnetron sputtering apparatus (10) according to claim 25, wherein the rotatable mounting means comprises a planetary gear arrangement which is rotatable in conjunction with rotation of the drum (2).

**27.** A magnetron sputtering apparatus (10) according to any one of the preceding claims, further comprising at least a second magnetron sputter device (5) or group of magnetron sputter devices adapted for depositing at least a second material onto substrates (3) at a second work station or group of work stations adjacent said substrate holder.

**28.** A magnetron sputtering apparatus (10) according to claim 27, further comprising at least a second secondary plasma device (6) or group of secondary plasma devices positioned adjacent the second magnetron sputter device (5) or group of magnetron sputter devices and adapted for providing a plasma (8) for enhancing the plasma (9) formed by the second magnetron sputter device or group of magnetron sputter devices.

**29.** Use of a magnetron sputtering apparatus (10) as defined in claim 28, wherein the magnetron sputter device (5) and the magnetron sputter and secondary plasma devices in combination are operated selectively and sequentially to form a composite coating comprising at least a plurality of layers, the composition of each said layer being selected from at least one member selected from a first metal, a second metal, an oxide of the first metal, an oxide of the second metal, mixtures of the first and second metals, and an oxide of mixtures of the first and second metals.

**30.** Use of a magnetron sputtering apparatus (10) according to claim 29, wherein selected ones of the magnetron sputter devices are operated sequentially to sputter deposit layers of selected materials on the substrate (3) and selected ones of the secondary plasma devices are operated selectively and sequentially in conjunction with supplying a selected reactant gas or combination of selected reactant gases thereto for effecting a reaction with at least selected ones of the layers prior to sputter deposition of the next successive layer.

**31.** Use of a magnetron sputtering apparatus (10) according to claim 30, wherein the reaction involves converting the selected layers to at least one member selected from an oxide, nitride, hydride, sulfide, oxynitride, or carbon-containing compound or mixture.

**32.** Use of a magnetron sputtering apparatus (10) according to claim 30 or 31, wherein the selected reaction is oxidation.

**33.** Use of a magnetron sputtering apparatus (10) according to any one of claims 29 to 32, wherein mixtures of materials are deposited that provide alternating layers of composite materials with high and low effective refractive index and approximately equal optical thickness, said alternating layers being repeated one or more times to produce a multilayer coating that provides a high reflectance peak of electromagnetic radiation at the effective quarter wave optical thickness of the multilayer stack and a broad band of high transmission at both longer and shorter wavelengths outside of the layer's peak reflectance band.

**34.** Use of a magnetron sputtering apparatus (10) according to claim 33, wherein each coating layer represents a continuously variable mixture of selected materials or reacted selected materials to provide a continuously variable index of refraction from that of a material having a high index of refraction in the mixture to that of material having a low index of refraction in the mixture, said index variation being reversed for each successive layer.

**35.** Use of a magnetron sputtering apparatus (10) according to claim 33 or 34, wherein coating layers are provided for the suppression of the higher order reflection bands in multilayer coatings.

**Patentansprüche**

**1.** Magetron-Sputtervorrichtung (10) zum Sputtern wenigstens eines ausgewählten Materials auf ein Substrat (3) und Bewirken einer Reaktion dieses Materials, wobei die Vorrichtung aufweist: eine Vakuumkammer, einen Substrathalter (2) innerhalb der Vakuumkammer, der zur Halterung von Substraten auf demselben geeignet ist, wobei der Substrathalter und die Vakuumkammer zwischen sich ein verhältnismäßig schmales langgestrecktes Reaktionsvolumen bilden, in das ein reaktives Gas eingeleitet wird, wenigstens eine Magnetron-Sputtereinrichtung (5), die in einer ersten Arbeitsstation nahe dem Substrathalter angeordnet ist und ein Target aus ausgewähltem Material aufweist, das zur Erzeugung eines ersten Plasmas (9) im ganzen Reaktionsvolumen zum Sputtern wenigstens eines ausgewählten Materials auf die Substrate geeignet ist, sowie wenigstens eine sekundäre Plasmaeinrichtung (6), dadurch gekennzeichnet, daß die sekundäre Plasmaeinrichtung in der ersten Arbeitsstation nahe der Magnetron-Sputtereinrichtung und nahe dem Substrathalter angeordnet ist, wobei die Sputtereinrichtung und die sekundäre Plasmaeinrichtung jeweils Sputter- und Aktivierungszonen bilden, die atmosphärisch und physikalisch benachbart sind, und zur Verbesserung des Plasmas der Sputtereinrichtung geeignet ist, um eine Reaktion der Ionen des reaktiven Gases mit dem Sputtermaterial unter einem verhältnismäßig niedrigen Umgebungsteildruck des reaktiven Gases zu bewirken, und daß der Substrathalter geeignet ist, die Substrate an den zugeordneten ausgewählten Arbeitsstationen vorbei zu drehen.

2. Magnetron-Sputtervorrichtung (10) nach Anspruch 1, bei welcher die verbesserte Plasmaeinrichtung, welche aus der Magnetron-Sputtereinrichtung (5) und der sekundären Plasmaeinrichtung (6) besteht, geeignet ist, eine reaktive Atmosphäre (11) zu bewirken, welche so gewählt ist, daß das ausgewählte Material wenigstens teilweise in wenigstens eine der folgenden Substanzen umgewandelt wird: ein Oxid, ein Nitrid, ein Hydrid, ein Oxynitrid oder eine Kohlenstoff enthaltende Legierung oder Verbindung.

3. Magnetron-Sputtervorrichtung (10) nach Anspruch 1, bei welcher die sekundäre Plasmaeinrichtung (6) in Verbindung mit der Magnetron-Sputtereinrichtung (5) geeignet ist, eine reaktive Amtosphäre (11) zu erzeugen, die so gewählt ist, daß die Umwandlung des ausgewählten Materials in wenigstens eine der folgenden Substanzen vervollständigt wird: ein Oxid, ein Nitrid, ein Hydrid, ein Oxynitrid oder eine Kohlenstoff enthaltende Legierung oder Verbindung, wobei die Umwandlung von der Magnetron-Sputtereinrichtung ausgelöst wird.

4. Magnetron-Sputtervorrichtung (10) nach einem der vorangehenden Ansprüche, bei welcher die sekundäre Plasmaeinrichtung (6) für die Reinigung des Substrats (3) in situ geeignet ist.

5. Magnetron-Sputtervorrichtung (10) nach einem der vorangehenden Ansprüche, bei welcher die sekundäre Plasmaeinrichtung (6) zum Beschießen des ausgewählten Materials durch energiegeladene Atome während des Bedampfens geeignet ist.

6. Magnetron-Sputtervorrichtung (10) nach einem der vorangehenden Ansprüche, bei welcher die sekundäre Plasmaeinrichtung (6) eine Mikrowellen-Generatoreinrichtung ist.

7. Magnetron-Sputtervorrichtung (10) nach Anspruch 6, bei welcher die sekundäre Plasmaeinrichtung (6) eine Mikrowellen-Generatoreinrichtung ist, die in einem Elektronenzyklotron-Resonanzmodus (ECR) arbeitet.

8. Magetron-Sputtervorrichtung (10) nach einem der Ansprüche 1 bis 5, bei welcher die sekundäre Plasmaeinrichtung (6) eine Ionenkanoneneinrichtung ist.

9. Magnetron-Sputtervorrichtung (10) nach einem der Ansprüche 1 bis 5, bei welcher die sekundäre Plasmaeinrichtung (6) eine lineare Magnetroneinrichtung ist, die in einem ausgeglichenen Magnetmodus arbeitet.

10. Magnetron-Sputtervorrichtung (10) nach einem der Ansprüche 1 bis 5, bei welcher die sekundäre Plasmaeinrichtung (6) eine lineare Magnetroneinrichtung ist, die in einem unausgeglichenen Magnetmodus arbeitet.

11. Magnetron-Sputtervorrichtung (10) nach Anspruch 9 oder 10, bei welcher die lineare Magnetroneinrichtung (6) aus einem Targetmaterial besteht, welches das gleiche Material ist wie das ausgewählte Material, und in einem vergifteten Modus (poisoned mode) betrieben wird.

12. Magetron-Sputtervorrichtung (10) nach Anspruch 9 oder 10, bei welcher die lineare Magnetroneinrichtung (6) aus einem Targetmaterial besteht, das aus einem Sputtermaterial mit niedrigerer Ausbeute als das ausgewählte Material besteht.

13. Magnetron-Sputtervorrichtung (10) nach einem der vorangehenden Ansprüche, bei welcher die sekundäre Plasmaeinrichtung (6) eine Erhitzung des Substrats bewirkt.

14. Magnetron-Sputtervorrichtung (10) nach einem der vorangehenden Ansprüche, bei welcher die Magnetron-Sputtereinrichtung (5) eine zylindrische Magnetroneinrichtung ist.

15. Magetron-Sputtervorrichtung (10) nach einem der Ansprüche 1 bis 13, bei welcher die Magnetron-Sputtereinrichtung (5) eine planare Mangetroneinrichtung ist.

16. Magetron-Sputtervorrichtung (10) nach Anspruch 15, bei welcher die planare Magnetroneinrichtung (5) in einem nicht ausgeglichenen Magnetmodus betrieben wird.

17. Magnetron-Sputtervorrichtung (10) nach einem der vorangehenden Ansprüche, bei welcher die Magnetron-Sputtereinrichtung (5) in Verbindung mit der sekundären Plasmaeinrichtung (6) für eine Sputterbeschichtung der ausgewählten Materialien bei Drücken unterhalb 133,3

18. Magetron-Sputtervorrichtung (10) nach einem der vorangehenden Ansprüche, bei welcher die Magnetron-Sputtereinrichtung (5) in Verbindung mit der sekundären Plasmaeinrichtung (6) zur Umwandlung des ausgewählten Materials in ein Oxid, ein Nitrid, ein Hydrid, ein Oxynitrid oder eine Kohlenstoff enthaltende Legierung oder Verbindung bei Drücken unterhalb 133,3

19. Magnetron-Sputtervorrichtung (10) nach einem der vorangehenden Ansprüche, bei welcher der Substrathalter (2) ein Band in einem Band-zu-Band-Rollbeschichter ist.

20. Magnetron-Sputtervorrichtung (10) nach einem der Ansprüche 1 bis 18, bei welcher der Substrathalter (2) eine Scheibe ist.

21. Magetron-Sputtervorrichtung (10) nach einem der Ansprüche 1 bis 10, bei welcher der Substrathalter (2) eine Trommel ist.

22. Magnetron-Sputtervorrichtung (10) nach Anspruch 21, bei welcher die sekundäre Plasmaeinrichtung (6) außerhalb der Trommel (2) angeordnet ist.

23. Magnetron-Sputtervorrichtung (10) nach Anspruch 21, bei welcher die sekundäre Plasmaeinrichtung (6) innerhalb der Trommel (2) angeordnet ist.

24. Magnetron-Sputtervorrichtung (10) nach Anspruch 21, bei welcher wenigstens eine sekundäre Plasmaeinrichtung (6) innerhalb der Trommel (2) angeordnet ist und wenigstens eine sekundäre Plasmaeinrichtung außerhalb der Trommel angeordnet ist.

25. Magnetron-Sputtervorrichtung (10) nach einem der Ansprüche 21 bis 24, mit einer Substratträgereinrichtung, welche nahe dem Umfang der Trommel drehbar gelagert ist, um ausgewählte Substrate (3) oder Oberflächenabschnitte derselben der Arbeitsstation (5,6) drehbar darzubieten.

26. Magnetron-Sputtervorrichtung (10) nach Anspruch 25, bei welcher die drehbar gelagerte Einrichtung eine Planetenradanordnung aufweist, die in Verbindung mit der Drehung der Trommel (2) drehbar ist.

27. Magetron-Sputtervorrichtung (10) nach einem der vorangehenden Ansprüche, mit wenigstens einer zweiten Magetron-Sputtereinrichtung (5) oder Gruppe von Magnetron-Sputtereinrichtungen, die zum Aufbringen wenigstens eines zweiten Materials auf Substrate (3) in einer zweiten Arbeitsstation oder Gruppe von Arbeitsstationen nahe dem Substrathalter geeignet sind.

28. Magnetron-Sputtervorrichtung (10) nach Anspruch 27, mit wenigstens einer zweiten sekundären Plasmaeinrichtung (6) oder Gruppe von sekundären Plasmaeinrichtungen, die nahe der zweiten Magnetron-Sputtereinrichtung (5) oder Gruppe von Magnetron-Sputtereinrichtungen angeordnet sind und zur Erzeugung eines Plasmas (8) für die Verbesserung des Plasmas (9) geeignet sind, welches von der zweiten Magnetron-Sputtereinrichtung oder Gruppe von Magetron-Sputtereinrichtungen gebildet wird.

29. Verwendung einer Magnetron-Sputtervorrichtung (10) nach Anspruch 28, bei welcher die Magnetron-Sputtereinrichtung (5) und die Magnetron-Sputter- und sekundären Plasmaeinrichtungen in Kombination selektiv und nacheinander betrieben werden, um eine zusammengesetzte Beschichtung zu bilden, die wenigstens eine Mehrzahl von Schichten umfaßt, wobei die Zusammensetzung jeder Schicht ausgewählt ist aus wenigstens einer der folgenden Substanzen: ein erstes Metall, ein zweites Metall, ein Oxid des ersten Metalls, ein Oxid des zweiten Metalls, Mischungen des ersten und zweiten Metalls und ein Oxid von Mischungen des ersten und zweiten Metalls.

30. Verwendung einer Magnetron-Sputtervorrichtung (10) nach Anspruch 29, bei welcher ausgewählte der Magnetron-Sputtereinrichtungen nacheinander betrieben werden, um Schichten der ausgewählten Materialien auf das Substrat (3) durch Sputtern aufzudampfen, und ausgewählte der zweiten Plasmaeinrichtungen selektiv und nacheinander in Verbindung mit der Zuleitung eines ausgewählten Reaktionsgases oder einer Kombination von ausgewählten Reaktiongasen in dieselben betrieben werden, um eine Reaktion mit wenigstens ausgewählten der Schichten vor dem Sputteraufdampfen der nächstfolgenden Schicht zu bewirken.

31. Verwendung einer Magnetron-Sputtervorrichtung (10) nach Anspruch 30, bei welcher die Reaktion die Umwandlung der ausgewählten Schichten in wenigstens eine Substanz umfaßt, die ausgewählt ist aus einem Oxid, Nitrid, Hydrid, Sulfid, Oxynitrid oder einer Kohlenstoff enthaltenden Verbindung oder Mischung.

32. Verwendung einer Magnetron-Sputtervorrichtung (10) nach Anspruch 30 oder 31, bei welcher die ausgewählte Reaktion Oxidation ist.

33. Verwendung einer Magnetron-Sputtervorrichtung (10) nach einem der Ansprüche 29 bis 32, bei welcher Mischungen von Materialien aufgedampft werden, die abwechselnde Schichten von zusammengesetzten Materialien mit hohem und niedrigem effektivem Brechungsindex und nahezu gleicher optischer Dicke erzeugen, wobei die abwechselnden Schichten ein- oder mehrmals wiederholt werden, um eine Mehrschicht-Beschichtung zu erzeugen, die eine hohe Spitze des Reflexionsvermögens für elektromagnetische Strahlung bei der wirksamen optischen Viertelwellenlängen-Dicke des Mehrschichtstapels und ein breites Band hoher Durchlässigkeit sowohl bei längeren als auch kürzeren Wellenlängen außerhalb des Bandes des Spitzenreflexionsvermögens der Schicht hervorruft.

34. Verwendung einer Magnetron-Sputtervorrichtung (10) nach Anspruch 33, bei welcher jede Schicht der Beschichtung einer kontinuierlich veränderlichen Mischung von ausgewählten Materialien oder zur Reaktion gebrachten ausgewählten Materialien darstellt, um einen kontinuierlich veränderlichen Brechungsindex gegenüber demjenigen eines Materials mit einem hohen Brechungsindex in der Mischung zu demjenigen eines Materials mit einem niedrigen Brechungsindex in der Mischung zu bewirken, wobei die Änderung des Brechungsindex sich für jede folgende Schicht umkehrt.

35. Verwendung einer Magnetron-Sputtervorrichtung (10) nach Anspruch 33 oder 34, bei welcher die Schichten der Beschichtung zur Unterdrückung der Reflexionsbänder höherer Ordnung in den Mehrschicht-Beschichtungen vorgesehen sind.

**Revendications**

1. Appareil de pulvérisation cathodique à magnétron (10) pour déposer par pulvérisation cathodique, sur un substrat (3), au moins une matière choisie et pour provoquer une réaction de ladite matière, lequel dispositif comprend : une chambre à vide ; un support de substrats (2) à l'intérieur de la chambre à vide, conçu pour y monter des substrats, le support de substrats et la chambre à vide définissant entre eux un volume de réaction allongé relativement étroit dans lequel on introduit un gaz de réaction ; au moins un dispositif de pulvérisation cathodique à magnétron (5) placé à un premier poste de travail adjacent audit support de substrats, et comprenant une cible de matière choisie conçue pour produire, dans le volume de réaction, un premier plasma (9) pour dépôt par pulvérisation cathodique d'au moins une matière choisie sur lesdits substrats ; et au moins un dispositif à plasma secondaire (6) ; caractérisé en ce que le dispositif à plasma secondaire est placé au premier poste de travail à côté du dispositif de pulvérisation cathodique à magnétron et à côté du support de substrats, ce par quoi le dispositif de pulvérisation cathodique et le dispositif à plasma secondaire créent, respectivement, des zones de pulvérisation cathodique et d'activation qui sont voisines des points de vue atmosphérique et physique, et est conçu pour renforcer le plasma du dispositif de pulvérisation cathodique pour provoquer la réaction d'ions du gaz de réaction avec la matière déposée par pulvérisation cathodique à une pression partielle ambiante relativement basse du gaz de réaction ; et en ce que le support de substrats est conçu pour faire tourner les substrats devant des postes de travail choisis associés.

2. Appareil de pulvérisation cathodique à magnétron (10) selon la revendication 1, dans lequel le dispositif à plasma renforcé constitué du dispositif de pulvérisation cathodique à magnétron (5) et du dispositif à plasma secondaire (6) est conçu pour procurer une atmosphère de réaction (11) choisie pour convertir, au moins partiellement, ladite matière choisie en au moins l'un d'un oxyde, d'un nitrure, d'un hydrure, d'un oxynitrure, ou d'un alliage ou composé contenant du carbone.

3. Appareil de pulvérisation cathodique à magnétron (10) selon la revendication 1, dans lequel le dispositif à plasma secondaire (6), en combinaison avec le dispositif à pulvérisation cathodique à magnétron (5), est conçu pour procurer une atmosphère de réaction (11) choisie pour une conversion complète de la matière choisie en au moins l'un d'un oxyde, d'un nitrure, d'un hydrure, d'un oxynitrure, ou d'un alliage ou composé contenant du carbone, ladite conversion étant initialisée par ledit dispositif de pulvérisation cathodique à magnétron.

4. Appareil de pulvérisation cathodique à magnétron (10) selon l'une quelconque des revendications précédentes, dans lequel le dispositif à plasma secondaire (6) est conçu pour nettoyer in situ le substrat (3).

5. Appareil de pulvérisation cathodique à magnétron (10) selon l'une quelconque des revendications précédentes, dans lequel le dispositif à plasma secondaire (6) est conçu pour bombarder la matière choisie par des atomes énergétiques pendant le dépôt.

6. Appareil de pulvérisation cathodique à magnétron (10) selon l'une quelconque des revendications précédentes, dans lequel le dispositif à plasma secondaire (6) est un dispositif générateur hyperfréquence.

7. Appareil de pulvérisation cathodique à magnétron (10) selon la revendication 6, dans lequel le dispositif à plasma secondaire (6) est un dispositif générateur hyperfréquence fonctionnant dans un mode résonance gyromagnétique (ECR).

8. Appareil de pulvérisation cathodique à magnétron (10) selon l'une quelconque des revendications 1 à 5, dans lequel le dispositif à plasma secondaire (6) est un dispositif de canon à ions.

9. Appareil de pulvérisation cathodique à magnétron (10) selon l'une quelconque des revendications 1 à 5, dans lequel le dispositif à plasma secondaire (6) est un dispositif à magnétron linéaire mis en oeuvre dans un mode magnétique équilibré.

10. Appareil de pulvérisation cathodique à magnétron (10) selon l'une quelconque des revendications 1 à 5, dans lequel le dispositif à plasma secondaire (6) est un dispositif à magnétron linéaire mis en oeuvre dans un mode magnétique déséquilibré.

11. Appareil de pulvérisation cathodique à magnétron (10) selon la revendication 9 ou 10, dans lequel le dispositif à magnétron linéaire (6) est constitué d'une matière de cible qui est la même matière que la matière choisie et est mis en oeuvre dans un mode empoisonné.

12. Appareil de pulvérisation cathodique à magnétron (10) selon la revendication 9 ou 10, dans lequel le dispositif à magnétron linéaire (6) est constitué d'une matière de cible qui est une matière à rendement de pulvérisation cathodique plus bas que la matière choisie.

13. Appareil de pulvérisation cathodique à magnétron (10) selon l'une quelconque des revendications précédentes, dans lequel le dispositif à plasma secondaire (6) fournit un chauffage au substrat.

14. Appareil de pulvérisation cathodique à magnétron (10) selon l'une quelconque des revendications précédentes, dans lequel le dispositif de pulvérisation cathodique à magnétron (5) est un dispositif à magnétron cylindrique.

15. Appareil de pulvérisation cathodique à magnétron (10) selon l'une quelconque des revendications 1 à 13, dans lequel le dispositif de pulvérisation cathodique à magnétron (5) est un dispositif à magnétron plan.

16. Appareil de pulvérisation cathodique à magnétron (10) selon la revendication 15, dans lequel le dispositif à magnétron plan (5) est mis en oeuvre dans un mode magnétique déséquilibré.

17. Appareil de pulvérisation cathodique à magnétron (10) selon l'une quelconque des revendications précédentes, dans lequel le dispositif de pulvérisation cathodique à magnétron (5), en combinaison avec le dispositif à plasma secondaire (6), est conçu pour le revêtement par pulvérisation cathodique des matières choisies à des pressions inférieures à $133,3 . 10^{-3}$ Pa ($10^{-3}$ Torr).

18. Appareil de pulvérisation cathodique à magnétron (10) selon l'une quelconque des revendications précédentes, dans lequel le dispositif de pulvérisation cathodique à magnétron (5), en combinaison avec le dispositif à plasma secondaire (6), est conçu pour convertir ladite matière choisie en un oxyde, un nitrure, un hydrure, un oxynitrure, ou un alliage ou composé contenant du carbone, à des pressions inférieures à $133,3 . 10^{-3}$ Pa ($10^{-3}$ Torr).

19. Appareil de pulvérisation cathodique à magnétron (10) selon l'une quelconque des revendications précédentes, dans lequel le support de substrats (2) est une bande dans un dispositif de revêtement à rouleau bande à bande.

20. Appareil de pulvérisation cathodique à magnétron (10) selon l'une quelconque des revendications 1 à 18, dans lequel le support de substrats (2) est un disque.

21. Appareil de pulvérisation cathodique à magnétron (10) selon l'une quelconque des revendications 1 à 18, dans lequel le support de substrats (2) est un tambour.

22. Appareil de pulvérisation cathodique à magnétron (10) selon la revendication 21, dans lequel le dispositif à plasma secondaire (6) est placé à l'extérieur du tambour (2).

23. Appareil de pulvérisation cathodique à magnétron (10) selon la revendication 21, dans lequel le dispositif à plasma secondaire (6) est placé à l'intérieur du tambour (2).

24. Appareil de pulvérisation cathodique à magnétron (10) selon la revendication 21, dans lequel au moins un dispositif à plasma secondaire (6) est placé à l'intérieur du tambour (2) et au moins un dispositif à plasma secondaire est placé à l'extérieur du tambour.

25. Appareil de pulvérisation cathodique à magnétron (10) selon l'une quelconque des revendications 21 à 24, comprenant en outre un moyen formant support de substrats monté mobile en rotation au voisinage de la circonférence du tambour pour présenter de façon mobile en rotation, au poste de travail (5, 6), des substrats choisis (3) ou des segments de surface de ceux-ci.

26. Appareil de pulvérisation cathodique à magnétron (10) selon la revendication 25, dans lequel le moyen de montage mobile en rotation comprend un agencement à engrenages planétaires qui est mobile en rotation en liaison avec la rotation du tambour (2).

27. Appareil de pulvérisation cathodique à magnétron (10) selon l'une quelconque des revendications précédentes, comprenant en outre au moins un deuxième dispositif de pulvérisation cathodique à magnétron (5), ou un groupe de dispositifs de pulvérisation cathodique à magnétron, conçu pour déposer au moins une deuxième matière sur des substrats (3), à un second poste de travail, ou à un groupe de postes de travail, au voisinage dudit support de substrats.

28. Appareil de pulvérisation cathodique à magnétron (10) selon la revendication 27, comprenant en outre au moins un deuxième dispositif à plasma secondaire (6), ou un groupe de dispositifs à plasma secondaires, disposé au voisinage du deuxième dispositif de pulvérisation cathodique à magnétron (5), ou du groupe de dispositifs de pulvérisation cathodique à magnétron, et conçu pour délivrer un plasma (8) pour renforcer le plasma (9) formé par le deuxième dispositif de pulvérisation cathodique à magnétron, ou le groupe de dispositifs de pulvérisation cathodique à magnétron.

29. Utilisation d'un appareil de pulvérisation cathodique à magnétron (10) tel que défini dans la revendication 28, dans laquelle le dispositif de pulvérisation cathodique à magnétron (5) et les dispositifs de pulvérisation cathodique à magnétron et à plasma secondaire, en combinaison, sont mis en oeuvre de manière sélective et de manière séquentielle pour former un revêtement composite comprenant au moins une pluralité de couches, la composition de chacune desdites couches étant choisie à partir d'au moins un élément choisi à partir d'un premier métal, d'un second métal, d'un oxyde du premier métal, d'un oxyde du second métal, de mélanges des premier et second métaux, et d'un oxyde de mélanges des premier et second métaux.

30. Utilisation d'un appareil de pulvérisation cathodique à magnétron (10) selon la revendication 29, dans lequel certains, choisis, des dispositifs de pulvérisation cathodique à magnétron sont mis en oeuvre de manière séquentielle pour déposer par pulvérisation cathodique des couches de matière choisie sur le substrat (3), et dans laquelle certains, choisis, des dispositifs à plasma secondaires sont mis en oeuvre de manière sélective et de manière séquentielle en liaison avec la délivrance à ceux-ci d'un gaz de réaction choisie, ou d'une combinaison de gaz de réaction choisis, pour provoquer une réaction avec au moins certaines, choisies, des couches, avant le dépôt par pulvérisation cathodique de la couche successive suivante.

31. Utilisation d'un appareil de pulvérisation cathodique à magnétron (10) selon la revendication 30, dans laquelle la réaction implique la conversion des couches choisies en au moins un élément choisi à partir d'un oxyde, d'un nitrure, d'un hydrure, d'un sulfure d'un oxynitrure, ou d'un composé ou mélange contenant du carbone.

32. Utilisation d'un appareil de pulvérisation cathodique à magnétron (10) selon la revendication 30 ou 31, dans laquelle la réaction choisie est l'oxydation.

33. Utilisation d'un appareil de pulvérisation cathodique à magnétron (10) selon l'une quelconque des revendications 29 à 32, dans laquelle on dépose des mélanges de matières qui créent des couches alternées de matières composites avec un indice de réfraction efficace haut et bas et une épaisseur optique approximativement égale, lesdites couches alternées étant répétées une ou plusieurs fois pour produire un revêtement multicouche qui fournit un pic de réflectance élevé de rayonnement électromagnétique à l'épaisseur optique quart d'onde efficace de l'empilement multicouche, et une bande large de forte transmission à la fois aux longueurs d'onde plus longues et plus courtes à l'extérieur de la bande de réflectance de pic de la couche.

34. Utilisation d'un appareil de pulvérisation cathodique à magnétron (10) selon la revendication 33, dans laquelle chaque couche de revêtement représente un mélange variable de manière continue de matières choisies, ou de matières choisies ayant réagi, pour fournir un indice de réfraction variable de manière continue à partir de celui d'une matière ayant un fort indice de réfraction dans le mélange jusqu'à celui d'une matière ayant un faible indice de réfraction dans le mélange, ladite variation d'indice étant inversée pour chaque couche successive.

35. Utilisation d'un appareil de pulvérisation cathodique à magnétron (10) selon la revendication 33 ou 34, dans laquelle des couches de revêtement sont prévues pour la suppression des bandes de réflexion d'ordre plus élevé dans des revêtements multicouches.

Figure 1

**Figure 2**

Figure 3

**Figure 4**

Figure 5

Figure 6

Figure 7

| Voltage V in Volts | Yield Y in Atoms/Ion | $1.85 \times 10^{-2} V^{1/2}$ |
|---|---|---|
| 200 | 0.2 | 0.3 |
| 600 | 0.5 | 0.5 |
| 1000 | 0.6 | 0.6 |
| 2000 | 0.9 | 0.8 |
| 5000 | 1.4 | 1.3 |

Figure 8

Fig 9

Fig 10

Fig 11